Europäisches Patentamt

European Patent Office

Office européen des brevets

(19)

(11) **EP 0 654 673 B1**

(12) **EUROPÄISCHE PATENTSCHRIFT**

(45) Veröffentlichungstag und Bekanntmachung des Hinweises auf die Patenterteilung:
**10.07.2002 Patentblatt 2002/28**

(51) Int Cl.$^7$: **G01R 27/18**, G01R 31/02

(21) Anmeldenummer: **94118162.0**

(22) Anmeldetag: **18.11.1994**

(54) **Verfahren und Einrichtung zur Isolationsüberwachung von ungeerdeten Gleich- und Wechselstromnetzen**

Method and apparatus for insulation monitoring in unearthed DC and AC networks

Méthode et dispositif pour la surveillance de l'isolation dans des réseaux continus et alternatifs non mis à la terre

(84) Benannte Vertragsstaaten:
**AT BE CH DE DK ES FR GB GR IE IT LI LU MC NL PT SE**

(30) Priorität: **24.11.1993 DE 4339946**

(43) Veröffentlichungstag der Anmeldung:
**24.05.1995 Patentblatt 1995/21**

(73) Patentinhaber: **Dipl.-Ing. Walther Bender GmbH & Co. KG**
**35305 Grünberg (DE)**

(72) Erfinder: **Schepp, Karl**
**D-35447 Reiskirchen - Saasen (DE)**

(74) Vertreter: **Schumacher, Bernd, Dipl.-Ing.**
**Am Schwaberg 13**
**63454 Hanau (DE)**

(56) Entgegenhaltungen:
**DE-A- 2 509 661       DE-A- 2 545 315**
**DE-A- 2 545 325       DE-A- 2 618 303**
**DE-A- 3 346 387**

**Beschreibung**

Die Erfindung betrifft ein Verfahren zur Isolationsüberwachung von ungeerdeten, einen unvermeidbaren ohmschen sowie kapazitiven Isolationswiderstand zwischen Netz und Erde aufweisenden elektrischen Gleichstromnetzen und Wechselstromnetzen - insbesondere solchen mit angeschlossenen Gleichrichtern und sonstigen Stromrichtern - mit einer abwechselnd verschiedene Impulsspannungswerte aufweisenden Impulswechselspannung, die über eine ohmsche Netzankopplung zwischen Netz und Erde an das zu überwachende Netz als Meßspannung angelegt wird, wobei für jeden Impulsspannungswert der Meßspannung der zeitliche Verlauf des vom momentanen Netz abhängigen Einschwingvorgangs des Meßstroms oder einer hiervon abgeleiteten Größe, wie einer Spannung, bis zum Erreichen des Einschwingzustands überwacht wird und der unmittelbar nach dem Einschwingen des Netzes auf diesen Impulsspannungswert zwischen Netz und Erde fließende Meßstrom, der von der Größe des ohmschen Isolationswiderstands des Netzes gegenüber Erde und von dem Impulsspannungswert abhängig ist, direkt oder indirekt als Meßstrom-Meßwert erfaßt wird, wobei dann unverzüglich der jeweilige Impulsspannungswert der Impulswechselspannung auf ihren zeitlich nächsten Impulsspannungswert umgeschaltet wird und wobei jeweils die Meßwertdifferenz zweier aufeinanderfolgender Meßstrom-Meßwerte zur Bestimmung des ohmschen Isolationswiderstands zwischen Netz und Erde benutzt wird.

Ein solches Verfahren ist in der DE-A-25 45 325 beschrieben. Bei diesem Verfahren werden die Einzelimpulse der Impulswechselspannung hinsichtlich ihrer Länge an das jeweils vorhandene Netz stets so angepaßt, daß unverzüglich dann auf den nächsten Impulsspannungswert umgeschaltet wird, wenn der überwachte Einschwingvorgang beendet ist. Dadurch erfolgt eine Anpassung des Meßverfahrens an die momentanen Netzverhältnisse, so daß sich kurze Meßzeiten erzielen lassen. Auf diese Weise entfällt die Notwendigkeit der Verwendung einer Impulswechselspannung mit auf die ungünstigsten Netzverhältnisse anzupassender und dadurch notwendigerweise relativ kleiner sowie konstanter Impulsfolgefrequenz. Das Meßergebnis des ohmschen Isolationswiderstandes kann nach diesem Verfahren bereits nach kürzerer Meßzeit erzielt werden, wobei auch bei ungünstigeren Netzverhältnissen eine Zeitersparnis von beispielsweise etwa 50% erzielbar ist. Die Verwendung einer Impulsüberlagerung mit einem "adaptiven Meßimpuls" im Sinne dieses Verfahrens führt auch zu einer einfachen Handhabung des Meßverfahrens, weil sich das Verfahren hinsichtlich der jeweiligen Impulslängen selbsttätig anpassen kann.

In reinen Wechselstromnetzen kann der ohmsche Teil des Isolationswiderstands des Netzes im Betrieb dadurch gemessen werden, daß dem Netz über eine ohmsche Netzankopplung zwischen Netz und Erde eine konstante Meßgleichspannung überlagert wird. Der aufgrund dieser Meßgleichspannung über die Netzankopplung, das Netz und den ohmschen Isolationswiderstand fließende Meßgleichstrom ist hinsichtlich seiner Größe proportional zur Größe des ohmschen Isolationswiderstandes, so daß dieser Widerstand aus dem Meßgleichstrom bzw. einem hieraus abgeleiteten Meßstrom-Meßwert, wie einer Spannung, bestimmt werden kann. Dabei können störende Frequenzeinflüsse durch einen Tiefpaß ausgefiltert werden.

In Gleichstromnetzen und in Wechselstromnetzen, in denen durch angeschlossene Gleich-, Wechsel- oder sonstige Stromrichter Ableitgleichströme sowie nieder- und hochfrequente Anteile auftreten können, die über den unvermeidbaren ohmschen Teil des Isolationswiderstands zwischen Netz und Erde fließen, addiert (oder subtrahiert) sich zum Meßgleichstrom eine auf einem Ableitgleichstrom beruhende Gleichstrom-Störkomponente, die bei Verwendung einer Meßgleichspannung zu Fehlmessungen führt. Zur Eliminierung dieser Störkomponente kann dem Netz statt einer Meßgleichspannung eine Impulswechselspannung mit unterschiedlichen Impulsspannungswerten überlagert werden. Um zusätzlich auch den kapazitiven Einfluß des Isolationswiderstandes zu eliminieren, wird der jeweilige Meßstrom-Meßwert stets erst nach dem Einschwingen des Netzes auf den jeweiligen Impulsspannungswert erfaßt. Aus der Differenz zweier aufeinanderfolgender Meßstrom-Meßwerte wird dann der ohmsche Isolationswiderstand bestimmt. Durch die Differenzbildung entfällt der Einfluß der Störkomponente.

Solche Verfahren mit Impulsüberlagerung sind beispielsweise auch in DE 33 46 387 C2, DE 25 09 661 C2 und in der deutschen Offenlegungsschrift 26 18 303 beschrieben. Diese Verfahren haben jedoch - im Unterschied zu dem beschriebenen und ebenfalls mit Impulsüberlagerung arbeitenden Verfahren aus der DE-A-25 45 325 - den Nachteil, daß der Meßtakt eines dabei benutzten Impulsgenerators für die Erzeugung der Impulswechselspannung stets fest auf den maximal zu erwartenden kapazitiven Isolationswiderstand (Ableitkapazität) zwischen Netz und Erde abgestimmt werden muß (das heißt, daß die maximal zu erwartende Zeitkonstante zum Einschwingen der Meßspannung auf das Netz berücksichtigt werden muß). Dieses führt zu teils extrem langen Meßzeiten. Wenn zur Verkürzung der Meßzeit dennoch ein kürzerer Meßtakt, also eine größere Impulsfolgefrequenz, gewählt wird, können sich erhebliche Meßwertverfälschungen ergeben.

Die geschilderten Probleme sind bei dem Verfahren aus der DE-A-25 45 325 ausgeräumt. Dieses Verfahren hat jedoch folgenden wesentlichen Nachteil: Da die Meßwerte stichprobenartig in einem festen Taktraster - also zu bestimmten Zeitpunkten - erfaßt werden, können in realen Netzen unvermeidbar auftretende Störfrequenzen, wie niederfrequente Störfrequenzen, die Messungen völlig verfälschen bzw. erheblich verlangsamen oder sogar unmöglich machen. Diese überlagerten Störfrequenzen beeinflussen direkt die Stichproben, so daß es in ungünstigen Fällen

EP 0 654 673 B1

nicht möglich ist, den Abschluß des Einschwingvorgangs korrekt festzustellen.

Der vorliegenden Erfindung liegt daher die Aufgabe zugrunde, das Verfahren gemäß dem Oberbegriff von Anspruch 1 so abzuändern, daß es bei beliebigen ungeerdeten Netzen auch unter Berücksichtigung auftretender Störfrequenzen sicher, genau und optimal schnell arbeitet.

Zur Lösung der gestellten Aufgabe zeichnet sich ein Verfahren der im Oberbegriff von Anspruch 1 genannten Art erfindungsgemäß durch die im Kennzeichen dieses Anspruchs aufgeführten Merkmale aus, nämlich dadurch, daß beim Überwachen des Einschwingvorgangs zur auswertungsmäßigen Unterdrückung einer Störfrequenz, die den Meßstrom oder eine hiervon abgeleitete Größe überlagert, durch arithmetische Mittelwertbildung in bestimmten, unmittelbar aufeinanderfolgenden Meßintervallen erhaltene Mittelwert-Meßproben des Meßstroms oder einer hiervon abgeleiteten Größe genommen werden, daß der Einschwingvorgang als beendet gilt, sobald sich zwei aufeinanderfolgende Mittelwert-Meßproben ausreichend wenig voneinander unterscheiden, und daß für die Auswertung die letzte Mittelwert-Meßprobe als der entsprechende Meßstrom-Meßwert berücksichtigt wird.

Im Rahmen der Erfindung erfolgt somit jeweils in unmittelbar aufeinanderfolgenden Mittelwert-Meßintervallen eine arithmetische Mittelwertbildung zwecks Bildung von zu vergleichenden Mittelwert-Meßproben. Der Einfluß von Störfrequenzen der genannten Art wird dadurch unterdrückt oder zumindest deutlich minimiert, weil eben keine stichprobenartigen Messungen wie bei dem bekannten Verfahren vorgenommen werden. Das neue Verfahren arbeitet dadurch auch unter Berücksichtigung realer Netzverhältnisse stabil und genau. Außerdem arbeitet dieses Verfahren schneller als das bekannte Verfahren, weil der Einschwingzustand optimal schnell erfaßbar ist und nicht wie bei dem bekannten Verfahren sehr leicht störfrequenzbedingte Verzögerungen bei der Feststellung des Einschwingzustands auftreten.

Gemäß den Weiterbildungen der Ansprüche 2 und 3 sollten die Längen der Mittelwert-Meßintervalle bei der Überwachung eines jeden Einschwingvorgangs mit der Zeit größer werden. Hierdurch soll verhindert werden, daß der Überwachungsvorgang vorzeitig dadurch abgebrochen wird, weil zu kleine, nicht mehr ohne weiteres meßbare Unterschiede der Meßproben auftreten. Durch das Vergrößern der Zeitabstände bzw. Meßintervalle wird erreicht, daß sich während des Einschwingvorgangs stets ausreichend große Meßproben-Unterschiede ergeben und somit das Ende des Einschwingvorgangs sicher erfaßbar ist. Zur Reduzierung der Meßzeit sollte anfangs ein möglichst kleiner Startwert gewählt werden, der bei den ungünstigsten Netzverhältnissen, also bei großer Zeitkonstante, gerade noch ein sicheres meßtechnisches Feststellen des Einschwingvorgangs ermöglicht.

Die Startwerte des Mittelwert - Meßintervalls lassen sich unter Berücksichtigung der jeweiligen Netzverhältnisse bevorzugt nach den Vorschriften der Ansprüche 4 bis 6 wählen.

Die während der Überwachung eines jeden Einschwingvorgangs erfolgende Vergrößerung der Mittelwert-Meßintervalle sollte zur Vereinfachung des Verfahrens und zur Erzielung einwandfreier Meßergebnisse bevorzugt nach den Vorschriften der Ansprüche 7 bis 9 erfolgen. Nach den Ansprüchen 8 und 9 kann erreicht werden, daß der Überwachungsvorgang bei einer maximalen meßtechnischen Auflösung von etwa 1% nicht vor Erreichen der ca. 6-fachen Zeitkonstante des Einschwingvorgangs endet, also nicht zu früh abgebrochen wird.

Mit den bevorzugten Weiterbildungen der Ansprüche 10 bis 13 lassen sich sehr günstige Verhältnisse für die Mittelwertbildung erzielen, indem die anfänglich angenommene Störfrequenz zur Bestimmung des jeweiligen Startwerts des Mittelwert-Meßintervalls dann, wenn sich kein eindeutiges Meßergebnis erzielen läßt, innerhalb einer bestimmten Grenze solange verkleinert wird, bis ein sicheres Meßergebnis vorliegt. Für den nächsten Meßzyklus kann die tatsächliche Größe einer vorhandenen größeren Störfrequenz gemessen und dann sofort bei der Festlegung des Startwerts berücksichtigt werden.

Gemäß den Ansprüchen 14 und 15 können sehr verschiedene Arten von Impulswechselspannungen eingesetzt werden. Wichtig ist dabei lediglich, daß die Einschwingvorgänge auf verschiedene Impulsspannungswerte erfolgen, beobachtet und durch Differenzbildung ausgewertet werden, wodurch die störenden Ableitgleichströme meßtechnisch eliminiert werden.

Die Erfindung wird nachfolgend unter anderem an zeichnerisch dargestellten Ausführungsbeispielen näher erläutert. Es zeigen:

Fig. 1 eine Einrichtung nach der vorliegenden Erfindung in einer prinzipiellen Übersichtsdarstellung,

Fig. 2 eine für eine Differenzbildung sorgende Subtrahierschaltung als Einzelteil der Einrichtung aus Fig 1,

Fig. 3 Einschwingvorgänge auf positive und negative Impulsspannungswerte mit einer Entnahme von Meßproben zu bestimmten Meßzeitpunkten,

Fig. 4 einen sich auf einen positiven Impulsspannungswert beziehenden Teil der Einschwingvorgänge mit einer Entnahme von Meßproben, die zur Eliminierung von Störfrequenzen durch Mittelwertbildung in bestimmten Meßintervallen gewonnen werden,

Fig. 5 eine Prüfschaltung zum Überwachen eines korrekten Erdanschlusses und einer korrekten Arbeitsweise einer Auswerteeinheit der Einrichtung,

Fig. 6 eine steuerbare Schaltung zum Erzeugen einer großen Ausgangsspannung mit gleich großen positiven und negativen Impulsspannungswerten aus einer kleinen Eingangsgleichspannung,

Fig. 7 in einer Vergleichsdarstellung den deutlichen zeitlichen Vorteil des erfindungsgemäßen Verfahrens mit einem "adaptiven" (längenmäßig angepaßten) Meßimpuls gegenüber dem bekannten Verfahren mit einem "statischen" (längenmäßig konstanten) Meßimpuls,

Fig. 8 ein erstes Ablaufdiagramm zum Bestimmen des ohmschen Teils des Isolationswiderstandes und

Fig. 9 ein vom ersten Ablaufdiagramm aufgerufenes zweites Ablaufdiagramm zum Bestimmen von Meßstrom-Meßwerten.

Zunächst wird auf das bekannte Verfahren mit einer Impulsüberlagerung von Meßimpulsen konstanter Impulsfolgefrequenz näher eingegangen.

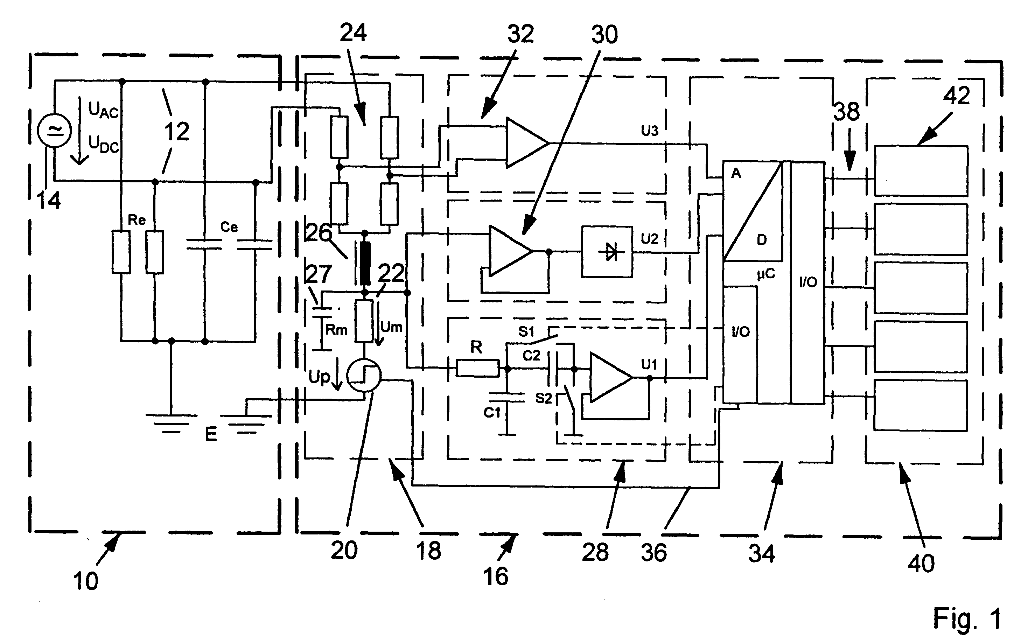

In Fig. 1 weist ein allgemein mit 10 bezeichnetes ungeerdetes Gleich- oder Wechselstromnetz im vorliegenden Fall zwei Netzleiter 12 auf, die von einer Netzspannungsquelle 14 mit Gleich- oder Wechselspannung ($U_{DC}$, $U_{AC}$) beaufschlagt sind. Ein unvermeidbarer Isolationswiderstand mit ohmschen und kapazitiven Teilen Re, Ce stellt auch bei korrekten Netzverhältnissen eine gewisse Netzableitung zwischen den Netzleitern 12 und Erde E dar. Die Größe des ohmschen Teils Re dieses Isolationswiderstands muß überwacht werden. Das erfolgt mittels einer Impulsüberlagerung. Zu diesem Zweck wird eine Überwachungseinrichtung 16 über eine ohmsche Netzankopplung 24 mit den Netzleitern 12 und Erde E verbunden.

Legt man gemäß Fig. 1 einen Meßimpuls mit einem Impulsspannungswert Up - Impulswechselspannungsquelle 20 - über eine ohmsche Netzankopplung 24 zwischen die Netzleiter 12 des Netzes 10 und Erde E, so fließt über den Isolationswiderstand ein Meßstrom, der nach dem Einschwingvorgang proportional zum ohmschen Teil Re des unvermeidbaren Isolationswiderstands (Parallelschaltung von Re, Ce) zwischen dem Netz sowie Erde ist und der vom Innenwiderstand Ri der Meßeinrichtung (hierzu gehört der ohmsche Widerstand der Netzankopplung) abhängt. An einem Meßwiderstand Rm - Widerstand 22 - kommt es zu einem Spannungsabfall Um, aus dem man den ohmschen Teil Re des Isolationswiderstands zwischen dem zu überwachenden Netz 12 und Erde E wie folgt berechnen kann:

$$Re= \frac{Up*Rm}{Um} -Ri$$

Der Einschwingvorgang beruht darauf, daß beim Einschalten des Meßimpulses zunächst der kapazitive Teil Ce des Isolationswiderstandes auf den Spannungswert Up*Re/(Ri+Re) aufgeladen werden muß, ehe der Meßstrom bzw. der hiervon abgeleitete Spannungsabfall (Meßstrom-Meßwert) an Rm als ein Maß für den ohmschen Teil des Isolationswiderstandes ausgewertet werden kann.

Bei in Betrieb befindlichen Gleich- und Wechselstromnetzen überlagern Ableitgleichströme das Meßergebnis, nämlich den Meßstrom-Meßwert. Deshalb werden bei der bekannten Impulsüberlagerung dem Netz nacheinander zwei Meßimpulse mit unterschiedlichen Impulsspannungswerten überlagert und die zugehörigen Meßstrom-Meßwerte erfaßt. Durch Differenzbildung dieser Meßstrom-Meßwerte entfällt der Einfluß der Ableitgleichströme.

Wenn beispielsweise zwei Meßimpulse mit gegenpoligen Impulsspannungswerten benutzt werden, läßt sich aus den beiden Spannungsabfällen Um1, Um2 an Rm der für die Bestimmung von Re maßgebliche Wert Um wie folgt berechnen:

$$Um= \frac{Um1-Um2}{2}$$

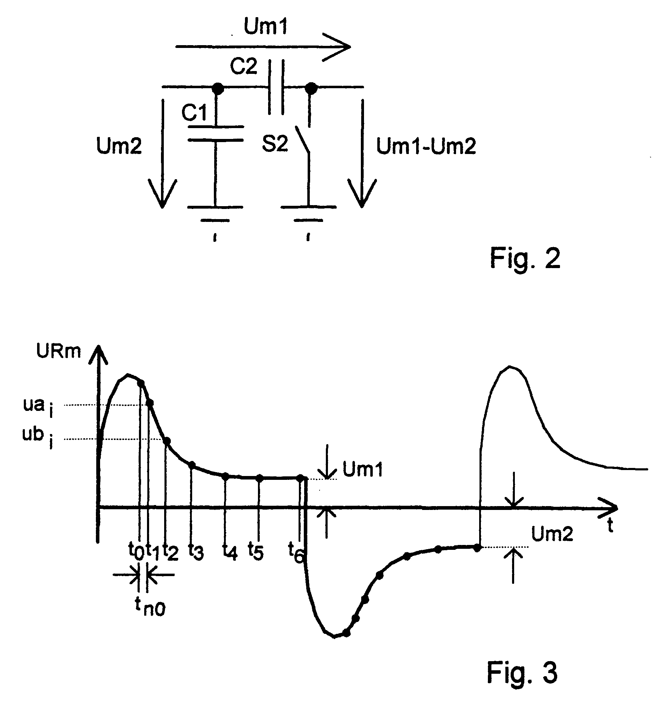

Die Subtraktion der beiden Spannungen erfolgt in bekannter Weise über eine sogenannte Sample&Hold-Schaltung gemaß Fig. 2. Zunächst wird die erste Spannung Um1 bei geschlossenem Schalter S2 angelegt, und die Kondensatoren C1 und C2 laden sich auf die Spannung Um1 auf. Dann werden der Schalter S2 geöffnet und die zweite Spannung Um2 angelegt. Dabei wird der Kondensator C1 auf die zweite Spannung Um2 aufgeladen, während der Kondensator C2 seine vorherige Spannung Um1 beibehält. Am Ausgang der Sample&Hold-Schaltung- bzw. am Eingang eines nachgeschalteten Meßverstärkers (siehe Fig. 1) - ergibt sich nun die auszuwertende Differenzspannung Um1-Um2.

Der wesentliche Nachteil des bekannten Impulsüberlagerungsverfahrens besteht darin, daß die Impulsdauer der mit einem fest eingestellten Impulsgenerator erzeugten Meßimpulse an die Länge des längstmöglichen Einschwingvorgangs und damit auch an den maximal möglichen kapazitiven Teil Ce des Isolationswiderstandes angepaßt werden muß. Wenn nämlich die Messungen vor dem Erreichen der Einschwingzustände erfolgen, treten deutliche Meßfehler bezüglich Re auf. Die Messungen können jeweils erst nach einer Meßzeit tmess vorgenommen werden, die etwa der 6-fachen Zeitkonstante entspricht und sich aus folgender Formel ergibt:

$$tmess = 6 * Re \parallel Ri * Ce$$

Hierbei stellt Re ∥ Ri den Widerstand der Parallelschaltung von Re und Ri dar. Da die Meßgröße Re maximal unendlich groß sein kann, beträgt tmess als einzustellende Mindestdauer für die einzelnen Meßimpulse 6 * Ri * Ce. Für einen vollen Meßzyklus (Differenzbildung der Meßstrom-Meßwerte bei zwei aufeinanderfolgenden Meßimpulsen) gilt demnach wenigstens die doppelte Mindestdauer.

Es folgt nunmehr die Beschreibung der Besonderheiten der vorliegenden Erfindung.

Im Rahmen der vorliegenden Erfindung werden keine fest eingestellten Meßimpulse mehr verwendet. Stattdessen werden die einzelnen Einschwingvorgänge auf verschiedene Impulsspannungswerte laufend überwacht, und die Meßimpulse werden jeweils sofort nach Erreichen der Einschwingzustände und nach Durchführung der Messungen beendet Es werden sozusagen "adaptive" Meßimpulse verwendet, deren zeitliche Länge laufend den jeweils vorhandenen Netzverhältnissen, nämlich den Größen von Ce und Re, angepaßt wird. Hierdurch lassen sich optimal kurze Meßzeiten erzielen.

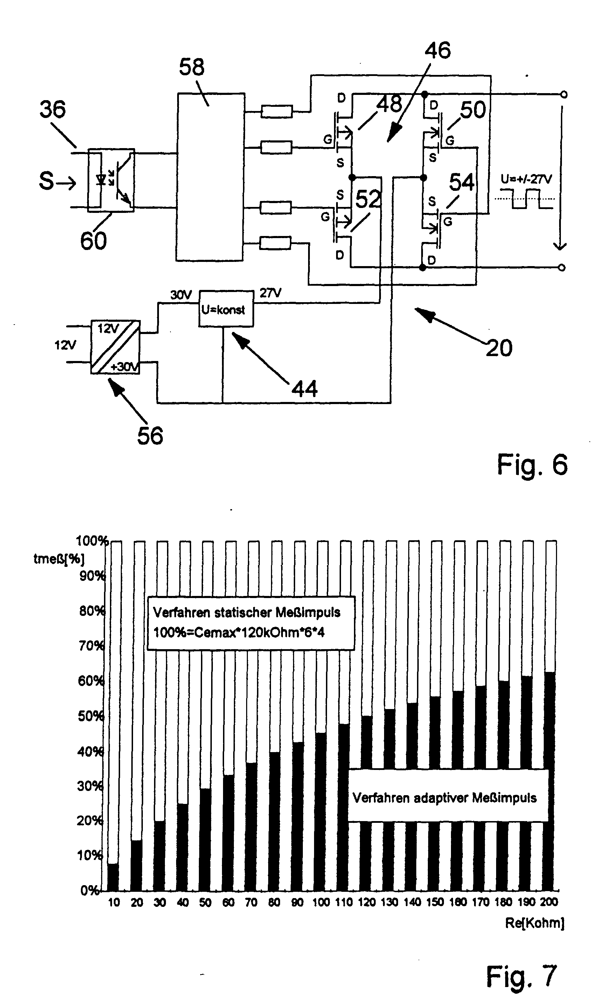

Aus Fig. 7 ist für ein Beispiel (Ce = 50 μF) der deutliche zeitliche Vorteil des erfindungsgemäßen Verfahrens gegenüber dem Stand der Technik dargestellt. Während nach dem Stand der Technik eine (auf Ce eingestellte) konstante Meßzeit tmess von 100% vorliegt, verkleinert sich die Meßzeit nach der Erfindung mit kleiner werdendem Re bis auf unter 10%. Für übliche Größen von Re vermindert sich die Meßzeit tmess auf etwa 50% bis 10%.

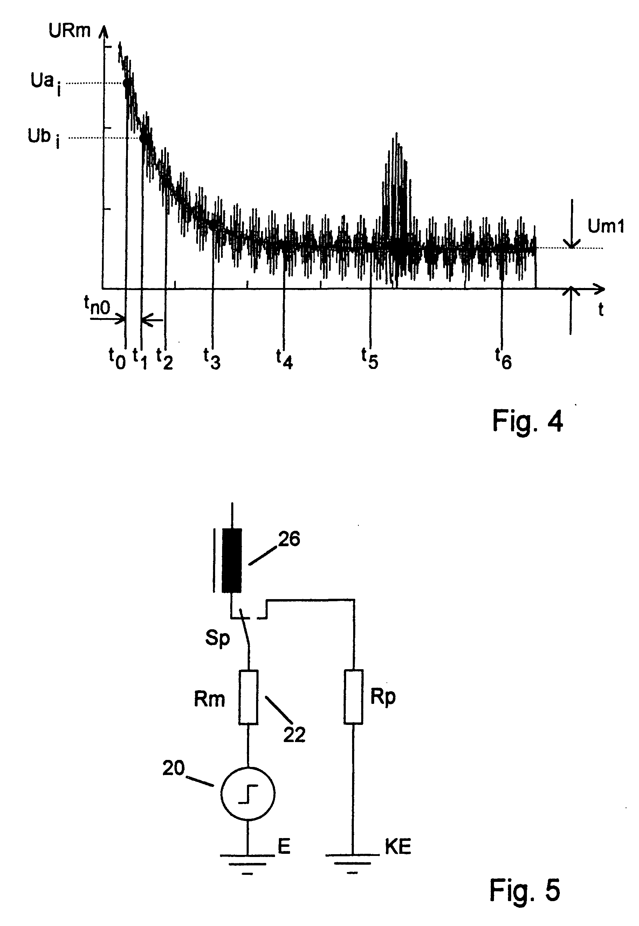

In den Figuren 3 und 4 ist für den Fall ohne Störfrequenzen (Fig. 3) und mit Störfrequenzen (Fig. 4) dargestellt, wie die Einschwingvorgänge der Spannung an Rm überwacht werden. Zu Beginn eines jeden Meßimpulses steigt die Spannung beim Aufladen von Ce steil an (begrenzt durch den Innenwiderstand Ri und leicht gedrosselt durch die Drossel 26), um dann nach einer e-Funktion auf den zu messenden Endwert Um1 bzw. Um2 (Meßstrom-Meßwert im eingeschwungenen Zustand) abzufallen bzw. bei negativem Impulsspannungswert anzusteigen.

Gemäß Fig. 3 werden bei jedem Meßimpuls zu bestimmten Meßzeitpunkten $t_0$ bis $t_6$ Meßproben der Spannung an Rm genommen. Wenn der Unterschied zweier aufeinanderfolgender Meßproben $Ua_i$ und $Ub_i$ ausreichend klein oder nicht mehr meßbar ist, gilt der Einschwingvorgang als beendet, und es wird der Meßstrom-Meßwert Um1 bzw. Um2 erfaßt.

Gemäß Fig. 4 werden die Meßproben dadurch erfaßt, daß in bestimmten Mittelwert-Meßintervallen zwischen $t_0$ und $t_1$; $t_1$ und $t_2$ etc. eine arithmetische Mittelwertbildung der Spannung an Rm erfolgt. Hierdurch lassen sich Störfrequenzen meßtechnisch eliminieren. Wenn der Unterschied zweier aufeinanderfolgender Meßproben $Ua_i$ und $Ub_i$ ausreichend klein oder nicht mehr meßbar ist, gilt der Einschwingvorgang als beendet, und es wird der Meßstrom-Meßwert Um1 bzw. Um2 erfaßt.

Die Abstände der Meßzeitpunkte bzw. die Längen der Mittelwert-Meßintervalle vergrößern sich mit der Zeit von einem Startwert $t_{n0}$ bzw. $t_{n0stör}$ ausgehend. Der Startwert sollte zwar möglichst klein sein, damit kurze Einschwingvorgänge (Re und/oder Ce klein) möglichst schnell erfaßt werden können. Der Startwert muß aber ausreichend groß sein, damit bei langen Einschwingvorgängen (Re und/oder Ce groß) diese wegen der kleinen Unterschiede der Meßproben und der begrenzten Meßauflösung nicht sofort als beendet behandelt werden.

Wenn bei dem Meßverfahren eine maximale digitale Meßauflösung a (die noch meßbare minimale prozentuale Meßwertänderung) angenommen wird - beispielsweise eine Meßauflösung von 0,01 (wie bei Verwendung einer Analog/Digital-Wandlung mit einem Wert von maximal 800 bit und mit minimal 8 bit Auflösung) - ergibt sich der zu wählende Startwert $t_{n0}$ aus folgendem Formelzusammenhang:

$$t_{n0} = -LN\ (1 - a\ ) * Ri * Cemax$$

$$t_{n0} = -\ LN\ (1 - 0,01) * Ri * Cemax$$

Hierin ist Cemax die maximal zu erwartende Netzableitkapazitat (kapazitiver Teil Ce des Isolationswiderstandes; Ce beträgt beispielsweise etwa 150 μF).

Dieser Startwert muß dann auf $t_{nOstör}$ vergrößert werden, wenn sich aufgrund einer vorhandenen Störfrequenz $f_{stör}$ der Wert von $t_{n0stör}$ größer erweist als $t_{n0}$. Der neue größere Startwert ergibt sich aus folgender Formel:

$$t_{nstör} = 1/\ f_{stör}$$

Dieser Startwert stellt bei niederfrequenten Störsignalen sicher, daß eine ausreichend lange Zeit für die Mittelwertbildung vorliegt und keine durch die Störfrequenz bedingten Fehlmessungen auftreten. Am Anfang wird ein bestimmter Anfangswert der Störfrequenz von beispielsweise 25 Hz angenommen - falls die tatsächliche Störfrequenz anders, insbesondere kleiner, sein sollte, erfolgt im Laufe des Meßverfahrens eine selbsttätige Anpassung.

Nach Festliegen des Startwertes werden bei der digitalen Überprüfung eines jeden Einschwingvorgangs jeweils zwei aufeinanderfolgende Mittelwert-Meßproben aus den Einzelwerten $Ua_i$ und $Ub_i$ nach folgendem Formelzusammenhang gebildet und verglichen:

$$\bar{U}_1 = \frac{t_{AD}}{t_n} \cdot \sum_{i=0}^{i=\frac{t_n}{t_{AD}}} Ua_i \qquad \bar{U}_2 = \frac{t_{AD}}{t_n} \cdot \sum_{i=0}^{i=\frac{t_n}{t_{AD}}} Ub_i \qquad t_{AD} = \text{Zeitdauer AD-Wandlung}$$

$$\frac{t_n}{t_{AD}} = \text{Anzahl der Messungen}$$

Der Einschwingzustand auf den Impulsspannungswert eines Meßimpulses liegt unter Berücksichtigung einer maximalen Meßauflösung a=0,01=8 bit dann vor, wenn folgende Gleichung erfüllt ist:

$$\left| \frac{t_{AD}}{t_n} \cdot \sum_{i=0}^{i=\frac{t_n}{t_{AD}}} Ua_i \;-\; \frac{t_{AD}}{t_n} \cdot \sum_{i=0}^{i=\frac{t_n}{t_{AD}}} Ub_i \right| < 8bit$$

Nach jeder Kontrolle der Einschwingbedingung muß die Zeit tn (Zeitabstand benachbarter Meßzeitpunkte bzw. die Länge des Mittelwert-Meßintervalls) für die nächste Kontrolle um einen bestimmten Faktor f vergrößert werden, damit die Einschwingbedingung nicht vor Erreichen einer Periodendauer von ca. 6 Zeitkonstanten, also 6*T, den Meßimpuls beendet.

Aus der Grundgleichung der e-Funktion kann man ableiten, daß zwischen den Zeitpunkten von 6 Zeitkonstanten und 4,38 Zeitkonstanten eine Wertedifferenz von 1% (8bit=1%) besteht. Dies bedeutet, daß die Zeit tn bei Messung des Endwertes, also bei Feststellung des Einschwingzustandes, ca. 6T-4.38T=1.62T betragen sollte. Daraus läßt sich ein optimierter Faktor f = 1,66 für die Vergrößerung der Zeit tn bis zum Feststellen der Einschwingbedingung ableiten.

Grundsätzlich ist es bei diesem Verfahren so, daß der nach der Differenzbildung berechnete Wert des ohmschen Isolationswiderstandes erst dann als richtiger Endwert verwertet wird, wenn die in zwei aufeinanderfolgenden Meßzyklen festgestellten Endwerte oder die Differenzwerte übereinstimmen. Damit lassen sich Fehlmessungen vermeiden, die beispielsweise darauf beruhen, daß sich die Netzverhältnisses zwischenzeitlich verändert haben oder daß die tatsächliche Störfrequenz $f_{stör}$ von dem angenommenen Anfangswert von 25 Hz meßwertverfälschend abweicht.

Wenn bei einem Meßzyklus keine zwei übereinstimmenden Differenz- oder Endwerte für den ohmschen Isolationswiderstand feststellbar sind (wie beim Auftreten sehr niederfrequenter Störsignale infolge einer dann vorhandenen Fehlanpassung der Meßintervalle an die Störfrequenz), wird der Startwert $t_{n0stör}$ (Meßintervall für die Mittelwertbildung der Meßprobe) für den nächsten Meßzyklus jeweils vergrößert, wie durch Halbierung von $f_{stör}$ verdoppelt. Diese Veränderung wird so oft fortgesetzt, bis zwei gleiche Endwerte festgestellt werden oder bis ein Minimalwert der Störfrequenz von beispielsweise 0,1 Hz erreicht ist. Damit erfolgt eine selbsttätige Anpassung der Meßintervalle an die tatsächliche Störfrequenz.

Dieses hat aber zur Folge, daß sich die Meßzeit entsprechend der Störfrequenz verlängert. Um die Meßzeit nach einem Meßzyklus schnell wieder einer größeren Störfrequenz anzupassen, wird am Ende eines Meßzyklus durch Zeitmessung zwischen Maximal.- und Minimalwerten die ungefähre Größe der Störfrequenz bestimmt. Ergibt sich eine tatsächliche Störfrequenz größer fstör, so werden fstör entsprechend angepaßt und damit das Mitteiwert-Meßintervall bzw. die Meßzeit entsprechend verkürzt.

Es folgt jetzt eine Beschreibung verschiedener Schaltungsdetails der Einrichtung nach der vorliegenden Erfindung.

Gemäß Fig.1 enthält ein Schaltungsteil 18 der Meßeinrichtung 16 die hintereinander zwischen Erde E und die Netzleiter 12 geschalteten, oben erwähnten Teile 20, 22 und 24. Zwischen der im vorliegenden Fall vier ohmsche Widerstände aufweisenden Netzankopplung 24 und dem Meßwiderstand 22 bzw Rm befindet sich ein Tiefpaß mit einer Drossel 26 und einem mit Erde E verbunden Kondensator 27. Der Tiefpaß sorgt für ein Ausfiltern der höherfrequenten Störanteile, wie auch der Netzfrequenz, aus dem Meßzweig.

Die Spannung am Meßwiderstand Rm bzw. 22 wird einer Subtrahierschaltung 28 mit einem eingangsseitigen Widerstand R und einem an diesen angeschlossenen Subtrahierglied in Form einer Sample&Hold-Schaltung zugeleitet, die zwei Kondensatoren C1, C2 und einen den Kondensator C2 im geschlossenen Zustand überbrückenden Schalter S2 aufweist. Das Subtrahierglied, das der Einzelheit aus Fig. 2 entspricht und entsprechend arbeitet, ist ausgangsseitig an einen nicht bezeichneten Meßverstärker angeschlossen, von dem aus das der Meßwertdifferenz Um1-Um2 entsprechende Ausgangssignal U1 zu einem Analog/Digital-Wandler A/D eines programmierbaren Mikrokontrollers 34 gelangt. Wie es bereits oben erläutert wurde, ist der vom Mikrokontroller 34 gesteuerte Schalter S2 zunächst geschlossen, bis nach erfolgtem Einschwingen Um1 in C2 gespeichert ist. Danach wird S2 geöffnet, und Um2 wird nach dem Einschwingen in C1 gespeichert.

Ein den Kondensator C2 im Schließzustand überbrückender, ebenfalls vom Mikrokontroller 34 gesteuerter Schalter S1, dient lediglich dem Zweck, die Funktion des Subtrahiergliedes für den Fall auszuschalten, daß eine Differenzbildung nicht erforderlich ist, beispielsweise dann, wenn in einem Wechselstromnetz aufgrund fehlender Stromrichter oder dergleichen keine störenden Ableitgleichströme im Netz 12 auftreten. Dann kann die Schaltung 28 die Spannung an Rm direkt zum Mikrokontroller 34 leiten.

Die Spannung am Meßwiderstand Rm bzw. 22 wird außerdem einer aktiven Gleichrichterschaltung 30 mit einem nicht bezeichneten Meßverstärker und einem daran angeschlossenen Gleichrichterglied zugeleitet. Dessen ebenfalls dem Analog/Digital-Wandler A/D des Mikrokontrollers 34 zugeleitete Ausgangssignal U2 stellt die gleichgerichteten Einschwingvorgänge der Spannung an Rm dar. Somit ist es mit diesem Signal U2 und dem Mikrokontrollers 34 grundsätzlich möglich, alle positiven und negativen Einschwingvorgänge zu überwachen und die Einschwingzustände festzustellen. Aus Gründen der Erhöhung der Meßgenauigkeit wird jedoch das durch Ableitgleichströme verfälschte Signal U2 nur zur Behandlung der negativen Einschwingvorgänge benutzt, während die positiven Einschwingvorgänge an dem kleineren nicht durch Ableitgleichströme verfälschten Differenzsignal U1 verfolgt werden.

Sobald der Mikrokontroller 34 durch die Meßprobenvergleiche einen Einschwingzustand feststellt, leitet er über eine Steuerleitung 36 ein Steuersignal S zu der Impulswechselspannungsquelle 20, die im vorliegenden Fall als eine umsteuerbare Spannungsquelle ausgebildet ist. Diese erzeugt in Abhängigkeit von dem Steuersignal S im vorliegenden Fall abwechselnd einen positiven und einen negativen Gleichspannungswert (gleich große positive und negative Impulsspannungswerte der Impulswechselspannung): Der jeweilige Impulsspannungswert bleibt stets solange erhalten, bis ein weiteres Steuersignal S eintrifft. Dadurch wird die Impulslänge der Meßimpulse durch den Mikrokontroller 34 immer den tatsächlichen Netzverhältnissen angepaßt, was zu einer optimalen Verkürzung der Meßzeiten führt.

Sobald der Mikrokontroller 34 durch die Auswertung von U1 feststellt, daß zwei aufeinanderfolgende Differenzwerte oder hieraus zu berechnende Endwerte für den ohmschen Isolationswiderstand Re im wesentlichen gleich groß sind, wird der letzte Wert von U1 für Re ausgewertet, und der Wert von Re wird über eine Leitungsverbindung 38 einem Interface 40 mit Einzelgliedern 42 zugeleitet. Die Einzelglieder können außer einem LCD-Display beispielsweise ein Auslöserelais für einen Fehlerfall, Bedientasten, eine serielle Schnittstelle und dergleichen mehr enthalten.

Über einen eingangsseitig an die Netzankopplung 24 und ausgangsseitig an den Analog/Digital-Wandler A/D angeschlossenen Differenzverstärker 32 wird die Netzspannung an den Netzleitern 12 erfaßt. Dadurch kann der Mikrokontroller 34 feststellen, ob die Meßeinrichtung tatsächlich an das zu überwachende Netz angeschlossen ist. Außerdem kann der Mikrokontroller 34 hierdurch über die Kurvenform feststellen, ob die Meßeinrichtung an ein Gleichstromnetz (mit einer zweipoligen Netzankopplung) oder an ein Wechselstromnetz (mit einer dreipoligen Netzankopplung) angeschlossen ist. Je nach Art des Netzes und des damit zusammenhängenden Innenwiderstandes der Netzankopplung kann dann eine selbsttätige Widerstandskorrektur vorgenommen werden. Stattdessen ist es aber auch möglich, die Art der Netzankopplung dem Mikrokontroller 34 über das Interface 40 manuell einzugeben.

Mit einer Prüfschaltung gemäß Fig. 5 kann überprüft werden, ob die Meßeinrichtung an Erde E angeschlossen ist und richtig arbeitet. Ein Prüfschalter Sp kann die Verbindung des Meßwiderstands Rm bzw. 22 mit der Drossel 26 aufheben und den Meßwiderstand stattdessen mit einem an eine Kontrollerde KE angeschlossenen ohmschen Prüfwiderstand Rp verbinden. Dieser ist so ausgelegt, daß er einen satten Erdschluß des zu überwachenden Netzes 10 simuliert. Damit muß die Auswerteeinheit der Meßeinrichtung einen ohmschen Isolationswiderstand Re = 0 Ohm anzeigen, wenn ein korrekter Erdanschluß vorliegt und die Auswerteeinheit korrekt arbeitet.

Ein praktisches Ausführungsbeispiel für die als umsteuerbare Spannungsquelle ausgebildete lmpulsspannungsquelle20istinFig.6dargestellt. EineausvierMOS-Feldeffekttransistoren 48, 50, 52, 54 bestehende Brückenschaltung 46 liefert über ihre Brückenendpunkte eine Ausgangsgleichspannung, die je nachdem, ob die diagonalen Transistoren 48, 54 oder 50, 52 durchgeschaltet sind, entweder+27V oder-27 V beträgt. Die zwischen diesen Werten umschaltbare Ausgangsgleichspannung stellt die Impulsspannungswerte der Impulswechselspannung dar. Die Brückenmittelpunkte sind an den Ausgang einer Gleichspannungsquelle 44 angeschlossen. Diese erzeugt im vorliegenden Fall aus einer kleinen Eingangsgleichspannung von 12V über einen galvanisch trennenden DC/DC-Wandler 56 eine Gleichspannung von 30V, aus der die stabilisierte Gleichspannung von 27V erzeugt wird. Die Steuerelektroden der Feldeffekttransistoren sind an den Ausgang einer Steuerlogik 58 angeschlossen, welche für das wechselseitige Durchschalten und Sperren der diagonalen Feldeffekttransistoren sorgt. Als Eingangssignal der Steuerlogik 58 dient das über die Steuerleitung 36 von dem Mikrokontroller 34 kommende Steuersignal S, welches der Steuerlogik über einen galvanisch trennenden Optokoppler 60 zugeleitet wird.

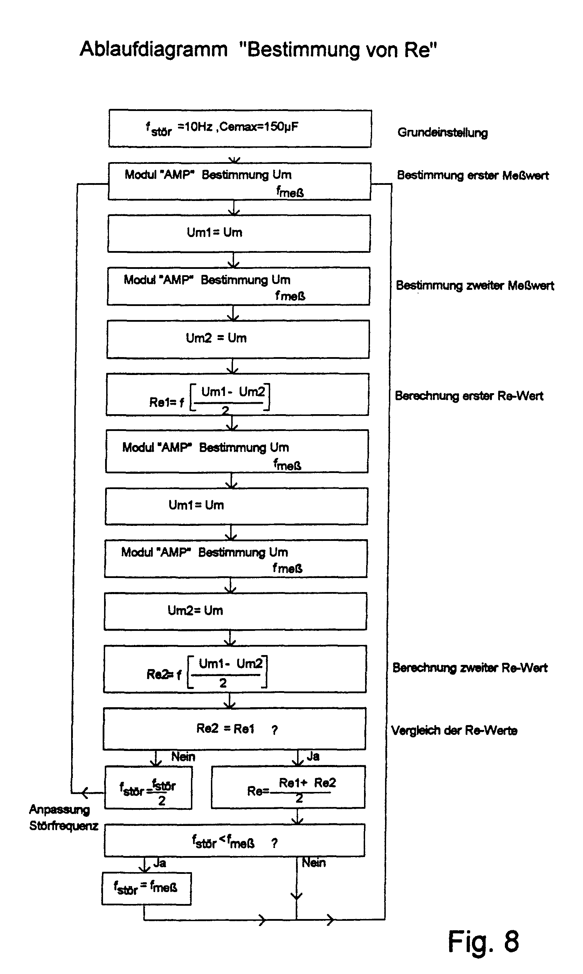

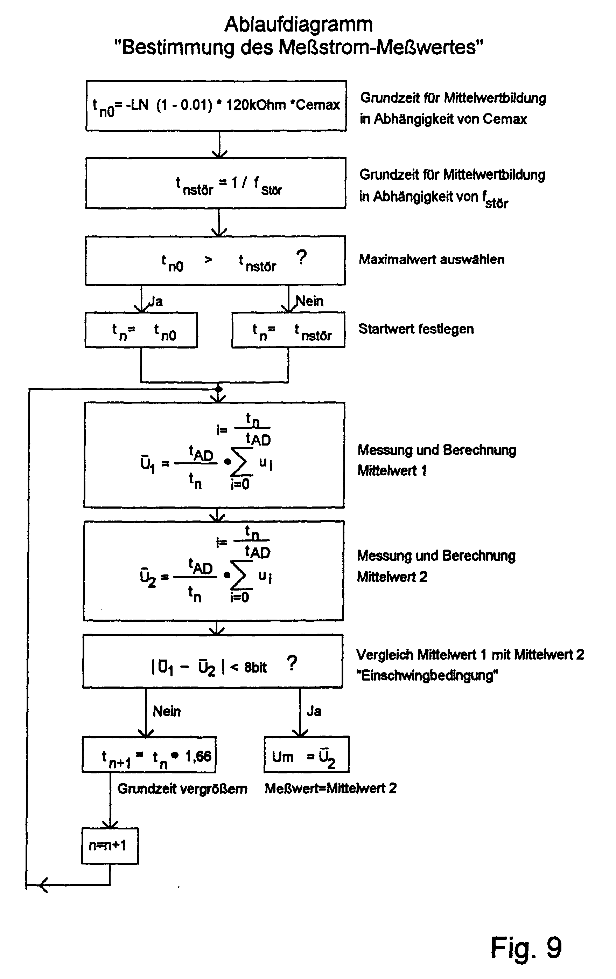

Die in den Fig. 8 und 9 dargestellten Ablaufdiagramme stellen wesentliche Schritte des Gesamtablaufs des Meßverfahrens dar.

Im Ablaufdiagramm von Fig. 8 wird zunächst eine Grundeinstellung mit Vorgabewerten für $f_{stör}$ und Cemax gewählt. Dann wird für jeden von zwei aufeinanderfolgenden Meßimpulsen das Ablaufdiagramm von Fig. 9 aufgerufen, um aus jeweils zwei durch Mittelwertbildung erhaltenen Meßproben die Einschwingbedingung zu überprüfen und für die beiden Meßimpulse jeweils den im Einschwingzustand maßgeblichen letzten Meßstrom-Meßwert Um1 (erster Impuls), Um2 (zweiter Impuls) zu bestimmen. Hieraus wird dann ein erster Isolationswert Re1 für Re berechnet. Der ganze Vorgang wird anschließend wiederholt, um einen zweiten Isolationswert Re2 für Re zu bestimmen. Wenn Re1 und Re2 betragsmäßig ganz oder nahezu übereinstimmen, wird davon ausgegangen, daß das Ergebnis richtig ist, und es wird der Mittelwert von Re1, Re2 als Maß für Re berechnet. Wenn allerdings keine übereinstimmenden Re1 und Re2 festgestellt werden konnten, wird mit halbiertem $f_{stör}$ neu begonnen. Nach der Berechnung von Re erfolgt vor Beginn eines neuen Meßzyklus erforderlichenfalls eine sofortige Festlegung von $f_{stör}$ auf den im Ablaufdiagramm von Fig. 9 festgestellten größeren Wert $f_{meß}$ des Störsignals.

Bei dem Ablaufdiagramm aus Fig. 9 wird zunächst der Startwert $t_{n0}$ der Meßintervalle für die Mittelwerterzeugung der Meßproben ermittelt. Dann werden jeweils zwei aufeinanderfolgende Meßproben verglichen. Dieser Vorgang wird unter Vergrößerung der Meßintervalle so oft wiederholt, bis zwei Meßproben übereinstimmen und die letzte Meßprobe als Meßstrom-Meßwert Um übernommen wird.

**Patentansprüche**

1. Verfahren zur Isolationsüberwachung von ungeerdeten, einen unvermeidbaren ohmschen sowie kapazitiven Isolationswiderstand zwischen Netz und Erde aufweisenden elektrischen Gleichstromnetzen und Wechselstromnetzen, insbesondere solchen mit angeschlossenen Gleichrichtern und sonstigen Stromrichtern,

   bei dem eine abwechselnd verschiedene Impulsspannungswerte ($U_p$) aufweisende Impulswechselspannung über eine ohmsche Netzankopplung (24) zwischen Netz und Erde an das zu überwachende Netz (10) als Meßspannung angelegt wird,

   wobei für jeden Impulsspannungswert der Meßspannung der zeitliche Verlauf des vom momentanen Netz abhängigen Einschwingvorgangs des Meßstroms oder einer hiervon abgeleiteten Größe, wie einer Spannung, bis zum Erreichen des Einschwingzustands überwacht wird,

   und der unmittelbar nach dem Einschwingen des Netzes auf diesen Impulsspannungswert zwischen Netz und Erde fließende Meßstrom, der von der Größe des ohmschen Isolationswiderstands des Netzes gegenüber Erde und von dem Impulsspannungswert abhängig ist, direkt oder indirekt als Meßstrom-Meßwert (Um) erfaßt wird,

   wobei dann unverzüglich der jeweilige Impulsspannungswert der Impulswechselspannung auf den zeitlich nächsten Impulsspannungswert umgeschaltet wird

   und wobei jeweils die Meßwertdifferenz zweier aufeinanderfolgender Meßstrom-Meßwerte zur Bestimmung des ohmschen Isolationswiderstands zwischen Netz und Erde benutzt wird,

   **dadurch gekennzeichnet,**

   **daß** beim Überwachen des Einschwingvorgangs zur auswertungsmäßigen Unterdrückung einer Störfrequenz ($f_{stör}$), die den Meßstrom oder eine hiervon abgeleitete Größe überlagert, durch arithmetische Mittelwertbildung in bestimmten, unmittelbar aufeinanderfolgenden Meßintervallen ($t_n$) erhaltene Mittelwert-Meßproben des Meßstroms oder einer hiervon abgeleiteten Größe genommen werden,

   **daß** der Einschwingvorgang als beendet gilt, sobald sich zwei aufeinanderfolgende Mittelwert-Meßproben ausreichend wenig voneinander unterscheiden,

   und **daß** für die Auswertung die letzte Mittelwert-Meßprobe als der entsprechende Meßstrom-Meßwert berücksichtigt wird.

2. Verfahren nach Anspruch 1, **dadurch gekennzeichnet, daß** beim Überwachen des Einschwingvorgangs die Mittelwert-Meßproben in mit der Zeit länger werdenden Mittelwert-Meßintervallen genommen werden.

3. Verfahren nach Anspruch 2, **dadurch gekennzeichnet, daß** der zu Beginn des Überwachungsvorgangs benutzte Startwert der Länge des Mittelwert-Meßintervalls gerade so groß gewählt wird, daß der größenmäßige Unterschied dieser Mittelwert-Meßpröben unter Berücksichtigung des Einschwingvorgangs für die größten zu erwartenden Werte des kapazitiven und ohmschen Isolationswiderstandes noch sicher feststellbar ist.

4.  Verfahren nach Anspruch 3, **dadurch gekennzeichnet, daß** der Startwert des Mittelwert-Meßintervalls unter Berücksichtigung eines unendlich großen ohmschen Isolationswiderstandes gewählt wird.

5.  Verfahren nach Anspruch 4, **dadurch gekennzeichnet, daß** der Startwert des Mittelwert-Meßintervalls nach der Formel

$$t_{n0} = -LN (1 - a) * Ri * Cemax$$

selbsttätig bestimmt und gewählt wird, wobei LN der natürliche Logarithmus des Klammerwertes, Ri der ohmsche Innenwiderstand der Netzankopplung für die Impulswechselspannung, Cemax der zu erwartende maximale kapazitive Isolationswiderstand und a die gerade noch meßbare minimale prozentuale Werteänderung der ersten Mittelwert-Meßprobe ist.

6.  Verfahren nach Anspruch 5, **dadurch gekennzeichnet, daß** der Startwert des Mittelwert-Meßintervalls nach der Formel

$$t_{n0stör} = 1 / f_{stör}$$

selbsttätig bestimmt und gewählt wird, sofern dieser Startwert aufgrund der auftretenden Störfrequenz $f_{stör}$ größer als der sich aus der Gleichung

$$t_{n0} = -LN (1-a)*Ri*Cemax$$

ergebende Startwert ist.

7.  Verfahren nach einem der Ansprüche 2 bis 6, **dadurch gekennzeichnet, daß** die Länge des zeitlich jeweils nächsten Mittelwert-Meßintervalls um einen konstanten Faktor gegenüber dem jeweils vorherigen Mittelwert-Meßintervall vergrößert wird.

8.  Verfahren nach Anspruch 7, **dadurch gekennzeichnet, daß** für die Vergrößerung der Mittelwert-Meßintervalle ein konstanter Faktor von ca. 1,5 bis 1,7 gewählt wird.

9.  Verfahren nach Anspruch 8, **dadurch gekennzeichnet, daß** für die Vergrößerung der Mittelwert-Meßintervalle ein optimierter konstanter Faktor von 1,66 gewählt wird.

10. Verfahren nach einem der Ansprüche 6 bis 9, **dadurch gekennzeichnet, daß** bei der Bestimmung des Startwerts des Mittelwert-Meßintervalls von einem anfänglichen Frequenzwert für die Störfrequenz ausgegangen wird, wie beispielsweise von 25 Hz bei einer Netzfrequenz von 50 Hz, und daß dann, wenn innerhalb dieses Meßzyklus für den ohmschen Isolationswiderstand nicht zwei im wesentlichen gleich große, aufeinanderfolgende Meßwertdifferenzen zweier zeitlich aufeinanderfolgender Meßstrom-Meßwerte, also auch nicht zwei im wesentlichen gleich große aufeinanderfolgende Ergebnisse für den ohmschen Isolationswiderstand, feststellbar sind, diese Meßwertdifferenz unberücksichtigt bleibt und der anfängliche Frequenzwert für den Startwert des Mittelwert-Meßintervalls des nächsten Meßzyklus selbsttätig verkleinert bzw. das Mittelwert-Meßintervall vergrößert wird.

11. Verfahren nach Anspruch 10, **dadurch gekennzeichnet, daß** der Frequenzwert für die Störfrequenz für den jeweils nächsten Meßzyklus um einen bestimmten Faktor so lange verkleinert, z.B. halbiert, wird, bis entweder zwei im wesentlichen gleich große aufeinanderfolgende Ergebnisse für den ohmschen Isolationswiderstand gefunden werden oder bis eine untere Frequenzwert-Grenze für die Störfrequenz, wie etwa 0,1 Hz, erreicht ist.

12. Verfahren nach Anspruch 10 oder 11, **dadurch gekennzeichnet, daß** nach erfolgter Verkleinerung des Frequenzwerts für die Störfrequenz am Ende des Meßzyklus für den ohmschen Isolationswiderstand, also am Ende des Einschwingvorgangs, die ungefähre Größe der Störfrequenz durch Zeitmessung zwischen den Maximal- und Minimalwerten ermittelt und hiervon abhängig der Startwert des Mittelwert-Meßintervalls für den nächsten Meßzyklus entsprechend festgelegt wird.

**13.** Verfahren nach Anspruch 12, **dadurch gekennzeichnet, daß** dann, wenn eine tatsächliche Störfrequenz ermittelt wird, die größer als der anfängliche Frequenzwert ist, der Startwert des Mittelwert-Meßintervalls entsprechend verkleinert wird.

**14.** Verfahren nach einem der Ansprüche 1 bis 13, **dadurch gekennzeichnet, daß** als Impulswechselspannung eine solche mit betragsmäßig unterschiedlich großen Impulsspannungswerten, insbesondere mit zwei Impulsspannungswerten, gleicher oder entgegengesetzter Polarität benutzt wird.

**15.** Verfahren nach einem der Ansprüche 1 bis 13, **dadurch gekennzeichnet, daß** als Impulswechselspannung eine solche mit betragsmäßig unterschiedlich großen Impulsspannungswerten, insbesondere mit zwei Impulsspannungswerten, benutzt wird, wobei einer der Impulsspannungswerte 0 V beträgt.

**Claims**

**1.** Method for insulation monitoring in unearthed electric dc and ac networks which have an unavoidable ohmic and capacitive insulation resistance between network and earth, in particular those with connected rectifiers and other converters, in which a pulsed alternating voltage which has alternatingly different pulsed voltage values ($U_p$) is applied as measuring voltage to the network (10) to be monitored via an ohmic network coupling (24) between network and earth, wherein for each pulsed voltage value of the measuring voltage the time characteristic of the instantaneous network-dependent transient phenomenon of the measured current or a variable derived therefrom, such as a voltage, is monitored until the transient state is reached, and the measured current flowing immediately after the transient condition of the network to this pulsed voltage value between network and earth, which measured current is dependent on the value of the ohmic insulation resistance of the network with respect to earth and on the pulsed voltage value, is detected directly or indirectly as the measured current reading (Um), wherein the respective pulsed voltage value of the pulsed alternating voltage is then immediately switched over to the temporally next pulsed voltage value and wherein the respective reading difference between two successive measured current readings is used to determine the ohmic insulation resistance between network and earth, **characterised in that** during monitoring of the transient phenomenon for evaluated suppression of an interference frequency ($f_{interference}$) which is superimposed on the measured current or a variable derived therefrom, average test samples of the measured current or a variable derived therefrom are taken by arithmetic averaging at specific, directly succeeding measuring intervals ($t_n$), **in that** the transient phenomenon ends as soon as two successive average test samples differ from one another to an adequately small extent, and **in that** the last average test sample is considered as the appropriate measured current reading for the evaluation.

**2.** Method according to claim 1, **characterised in that** during monitoring of the transient phenomenon the average test samples are taken at average measuring intervals which become longer over time.

**3.** Method according to claim 2, **characterised in that** the starting value, used at the beginning of the monitoring method, of the length of the average measuring interval is selected to be just large enough that the size difference between these average test samples cannot yet be reliably established taking into consideration the transient phenomenon for the largest values to be expected of the capacitative and ohmic insulation resistance.

**4.** Method according to claim 3, **characterised in that** the starting value of the average measured interval is selected taking into consideration an infinitely large ohmic insulation resistance.

**5.** Method according to claim 4, **characterised in that** the starting value of the average measured interval is automatically determined and selected according to the formula

$$t_{n0} = - LN\,(1-a)*Ri*Cemax$$

LN being the natural logarithm of the bracket value, Ri the ohmic internal resistance of the network coupling for the pulsed alternating voltage, Cemax the maximum capacitative insulation resistance to be expected and a the just measurable minimum percentage value change of the first average test sample.

**6.** Method according to claim 5, **characterised in that** the starting value of the average measured interval is automatically determined and selected according to the formula

$$t_{n0interference} = 1/f_{interference}$$

inasmuch as this starting value, due to the occurring interfering frequency $f_{interference}$, is greater than the starting value produced by the equation

$$t_{n0} = -LN (1-a)*Ri*Cemax.$$

**7.** Method according to any one of claims 2 to 6, **characterised in that** the length of the temporally next respective average measured interval is increased by a constant factor relative to the respective previous average measured interval.

**8.** Method according to claim 7, **characterised in that** a constant factor of approximately 1.5 to 1.7 is selected for the increase in the average measured intervals.

**9.** Method according to claim 8, **characterised in that** an optimised constant factor of 1.66 is selected for the increase in the average measured intervals.

**10.** Method according to any one of claims 6 to 9, **characterised in that** when the starting value of the average measured interval is determined, an initial frequency value for the interference frequency is used as a base, such as, for example, 25 Hz at a network frequency of 50 Hz, and, **in that** when, within this measuring cycle, no two substantially equal successive reading differences between two temporally successive measured current readings, i.e. no two substantially equal successive results for the ohmic insulation resistance can be determined for the ohmic insulation resistance, this reading difference is disregarded and the initial frequency value for the starting value of the average measured interval of the next measuring cycle is automatically reduced or the average measured interval is increased.

**11.** Method according to claim 10, **characterised in that** the frequency value for the interference frequency is reduced for the next respective measuring cycle by a specific factor, for example halved, until either two substantially identical successive results are found for the ohmic insulation resistance or until a lower frequency value limit is found for the interference frequency, such as 0.1 Hz.

**12.** Method according to claim 10 or 11, **characterised in that** after reduction of the frequency value for the interference frequency at the end of the measuring cycle for the ohmic insulation resistance, i.e. at the end of the transient phenomenon, the approximate size of the interference frequency is determined by time measurement between the peaks and troughs and, as a function thereof, the starting value of the average measured interval is correspondingly established for the next measuring cycle.

**13.** Method according to claim 12, **characterised in that** when an actual interference frequency is determined which is greater than the initial frequency value, the starting value of the average measured interval is correspondingly reduced.

**14.** Method according to any one of claims 1 to 13, **characterised in that** the pulsed alternating voltage used is of the type which has pulsed voltage values which differ in amount, in particular with two pulsed voltage values of identical or opposite polarity.

**15.** Method according to any one of claims 1 to 13, **characterised in that** the pulsed alternating voltage used is of the type with pulsed voltage values differing in amount, in particular with two pulsed voltage values, one of the pulsed voltage values being 0 V.

**Revendications**

**1.** Procédé de contrôle d'isolement de réseaux continus et de réseaux alternatifs électriques non mis à la terre, présentant une résistance d'isolement inévitable, ohmique ainsi que capacitive, entre le réseau et la terre, en particulier de tels réseaux avec des redresseurs et autres convertisseurs de courant raccordés,

dans lequel une tension alternative pulsée, présentant en alternance différentes valeurs de tension pulsée ($U_p$), est appliquée en tant que tension de mesure au réseau (10) à contrôler par l'intermédiaire d'un couplage de réseau ohmique (24) entre le réseau et la terre,

l'allure dans le temps du phénomène transitoire, dépendant du réseau momentané, du courant de mesure ou d'une grandeur dérivée de ce dernier, telle qu'une tension, étant contrôlée jusqu'à l'obtention du régime transitoire pour chaque valeur de tension d'impulsion de la tension de mesure,

et le courant de mesure passant entre le réseau et la terre immédiatement après l'établissement du réseau à cette valeur de tension pulsée, qui est dépendant de la valeur de la résistance d'isolement ohmique du réseau par rapport à la terre et de la valeur de tension pulsée, étant enregistré directement ou indirectement en tant que valeur de mesure du courant de mesure (Um),

chaque valeur de tension pulsée de la tension alternative pulsée étant ensuite immédiatement commutée sur la valeur suivante dans le temps de la tension pulsée

et chaque différence de valeurs de mesure entre deux valeurs successives de courant de mesure étant utilisée pour la détermination de la résistance d'isolement ohmique entre le réseau et la terre,

**caractérisé en ce**

**que** lors du contrôle du phénomène transitoire pour la suppression pour exploitation d'une fréquence parasite ($f_{stör}$), qui se superpose au courant de mesure ou à une grandeur dérivée de ce dernier, des échantillons de valeur moyenne du courant de mesure ou d'une grandeur dérivée de ce dernier, obtenus par moyenne arithmétique dans des intervalles de mesure déterminés ($t_n$) qui se succèdent immédiatement, sont prélevés,

**que** le phénomène transitoire est jugé achevé dès que deux échantillons de mesure successifs de la valeur moyenne diffèrent suffisamment peu l'un de l'autre,

et **que** le dernier échantillon de mesure de la valeur moyenne est pris en compte pour l'exploitation comme valeur de mesure adéquate du courant de mesure.

2. Procédé suivant la revendication 1, **caractérisé en ce que**, lors du contrôle du phénomène transitoire, les échantillons de mesure de la valeur moyenne sont pris dans des intervalles de mesure de plus en plus longs.

3. Procédé suivant la revendication 2, **caractérisé en ce que** la valeur de départ de la durée de l'intervalle de mesure de la valeur moyenne, utilisée au début de l'opération de contrôle, est choisie juste assez grande pour que la différence de grandeur de ces échantillons de mesure de la valeur moyenne, en tenant compte du phénomène transitoire, soit encore déterminable de façon sûre pour les valeurs maximales prévisibles de la résistance d'isolement capacitive ou ohmique.

4. Procédé suivant la revendication 3, **caractérisé en ce que** la valeur de départ de l'intervalle de mesure de la valeur moyenne est choisie en tenant compte d'une résistance d'isolement ohmique infiniment grande.

5. Procédé suivant la revendication 4, **caractérisé en ce que** la valeur de départ de l'intervalle de mesure de la valeur moyenne est définie et choisie automatiquement suivant la formule

$$t_{nO} = - LN (1 - a) * Ri * Cemax$$

LN étant le logarithme naturel de la valeur entre parenthèses, Ri la résistance interne ohmique du couplage de réseau pour la tension alternative pulsée, Cemax la résistance d'isolement capacitive maximale prévisible, et a la variation de valeur en pourcentage minimale encore juste mesurable du premier échantillon de mesure de la valeur moyenne.

6. Procédé suivant la revendication 5, **caractérisé en ce que** la valeur de départ de l'intervalle de mesure de la valeur moyenne est définie et choisie automatiquement d'après la formule

$$t_{nOstör} = 1/f_{stör}$$

dans la mesure où cette valeur de départ, en raison de la fréquence parasite $f_{stör}$ intervenant, est supérieure à la valeur de départ résultant de l'équation

$$t_{nO} = -LN(1 - a) * Ri * Cemax.$$

**7.** Procédé suivant l'une des revendications 2 à 6, **caractérisé en ce que** la durée de chaque intervalle de mesure de la valeur moyenne suivant dans le temps est augmentée d'un facteur constant par rapport à l'intervalle de mesure de la valeur moyenne précédent.

**8.** Procédé suivant la revendication 7, **caractérisé en ce qu'**un facteur constant d'environ 1,5 à 1,7 est choisi pour l'augmentation de l'intervalle de mesure de la valeur moyenne.

**9.** Procédé suivant la revendication 8, **caractérisé en ce qu'**un facteur constant optimisé de 1,66 est choisi pour l'augmentation de l'intervalle de mesure de la valeur moyenne.

**10.** Procédé suivant l'une des revendications 6 à 9, **caractérisé en ce que**, lors de la détermination de la valeur de départ de l'intervalle de mesure de la valeur moyenne, on part d'une valeur de fréquence initiale pour la fréquence parasite, comme par exemple de 25 Hz pour une fréquence de réseau de 50 Hz, et qu'ensuite, lorsqu' on ne peut constater à l'intérieur de ce cycle de mesure pour la résistance d'isolement ohmique deux différences de valeurs de mesure successives essentiellement égales entre deux valeurs de mesure de courant successives dans le temps, ni par conséquent deux résultats successifs essentiellement égaux pour la résistance d'isolement ohmique, cette différence de valeurs de mesure n'est pas prise en compte et la valeur de fréquence initiale pour la valeur de départ de l'intervalle de mesure de la valeur moyenne du cycle de mesure suivant est automatiquement réduite ou l'intervalle de mesure de la valeur moyenne est augmenté.

**11.** Procédé suivant la revendication 10, **caractérisé en ce que** la valeur de fréquence pour la fréquence parasite pour chaque cycle de mesure suivant est réduite d'un facteur déterminé, par exemple divisée par deux, jusqu'à ce que deux résultats successifs essentiellement égaux soient trouvés pour la résistance d'isolement ohmique ou jusqu'à ce qu'un seuil inférieur de valeur de fréquence soit atteint pour la fréquence parasite, tel qu'environ 0,1 Hz.

**12.** Procédé suivant l'une des revendications 10 et 11, **caractérisé en ce que**, après la réduction de la valeur de fréquence pour la fréquence parasite, à la fin du cycle de mesure pour la résistance d'isolement ohmique, donc à la fin du phénomène transitoire, la valeur approximative de la fréquence parasite est déterminée par chronométrage entre les valeurs maximale et minimale, et la valeur de départ de l'intervalle de mesure de la valeur moyenne pour le cycle de mesure suivant est fixée en conséquence en fonction de cette valeur.

**13.** Procédé suivant la revendication 12, **caractérisé en ce que**, lorsqu'une fréquence parasite effective supérieure à la valeur de fréquence initiale est déterminée, la valeur de départ de l'intervalle de mesure de la valeur moyenne est réduite en conséquence.

**14.** Procédé suivant l'une des revendications 1 à 13, **caractérisé en ce qu'**on utilise comme tension alternative pulsée une tension ayant des valeurs de tension pulsée de grandeurs différentes, en particulier deux valeurs de tension pulsée, de même polarité ou de polarité contraire.

**15.** Procédé suivant l'une des revendications 1 à 13, **caractérisé en ce qu'**on utilise comme tension alternative pulsée une tension ayant des valeurs de tension pulsée de grandeurs différentes, en particulier deux valeurs de tension pulsée, l'une des valeurs de tension pulsée étant de 0 V.

Fig. 1

EP 0 654 673 B1

Fig. 2

Fig. 3

Fig. 4

Fig. 5

**Fig. 6**

**Fig. 7**

## Ablaufdiagramm "Bestimmung von Re"

| | |
|---|---|
| $f_{stör} = 10Hz$, $C_{emax} = 150\mu F$ | Grundeinstellung |
| Modul "AMP" Bestimmung Um $f_{meß}$ | Bestimmung erster Meßwert |
| Um1 = Um | |
| Modul "AMP" Bestimmung Um $f_{meß}$ | Bestimmung zweiter Meßwert |
| Um2 = Um | |
| $Re1 = f\left[\dfrac{Um1 - Um2}{2}\right]$ | Berechnung erster Re-Wert |
| Modul "AMP" Bestimmung Um $f_{meß}$ | |
| Um1 = Um | |
| Modul "AMP" Bestimmung Um $f_{meß}$ | |
| Um2 = Um | |
| $Re2 = f\left[\dfrac{Um1 - Um2}{2}\right]$ | Berechnung zweiter Re-Wert |
| Re2 = Re1 ? | Vergleich der Re-Werte |

Nein

Ja

$f_{stör} = \dfrac{f_{stör}}{2}$

$Re = \dfrac{Re1 + Re2}{2}$

Anpassung
Störfrequenz

$f_{stör} < f_{meß}$ ?

Ja

Nein

$f_{stör} = f_{meß}$

## Fig. 8

## Ablaufdiagramm
## "Bestimmung des Meßstrom-Meßwertes"

$t_{n0} = -LN\ (1 - 0.01) * 120kOhm * Cemax$ — Grundzeit für Mittelwertbildung in Abhängigkeit von Cemax

$t_{nstör} = 1\ /\ f_{Stör}$ — Grundzeit für Mittelwertbildung in Abhängigkeit von $f_{stör}$

$t_{n0} > t_{nstör}$ ? — Maximalwert auswählen

Ja → $t_n = t_{n0}$    Nein → $t_n = t_{nstör}$ — Startwert festlegen

$$\bar{U}_1 = \frac{t_{AD}}{t_n} \cdot \sum_{i=0}^{i=\frac{t_n}{t_{AD}}} u_i$$

Messung und Berechnung Mittelwert 1

$$\bar{U}_2 = \frac{t_{AD}}{t_n} \cdot \sum_{i=0}^{i=\frac{t_n}{t_{AD}}} u_i$$

Messung und Berechnung Mittelwert 2

$|\bar{U}_1 - \bar{U}_2| < 8bit$ ? — Vergleich Mittelwert 1 mit Mittelwert 2 "Einschwingbedingung"

Nein → $t_{n+1} = t_n \cdot 1{,}66$    Ja → $Um = \bar{U}_2$

Grundzeit vergrößern    Meßwert=Mittelwert 2

$n = n+1$

# Fig. 9